Europäisches Patentamt

European Patent Office

Office européen des brevets

(11) Veröffentlichungsnummer : **0 314 732 B1**

(12) **EUROPÄISCHE PATENTSCHRIFT**

(45) Veröffentlichungstag der Patentschrift :
**11.03.92 Patentblatt 92/11**

(21) Anmeldenummer : **88904211.5**

(22) Anmeldetag : **05.05.88**

(86) Internationale Anmeldenummer :
**PCT/EP88/00381**

(87) Internationale Veröffentlichungsnummer :
**WO 88/09565 01.12.88 Gazette 88/26**

(51) Int. Cl.⁵ : **H01J 61/86, H01J 61/12**

(54) **XENON-KURZBOGEN-ENTLANDUNGSLAMPE.**

(30) Priorität : **16.05.87 DE 3716485**

(43) Veröffentlichungstag der Anmeldung :
**10.05.89 Patentblatt 89/19**

(45) Bekanntmachung des Hinweises auf die
Patenterteilung :
**11.03.92 Patentblatt 92/11**

(84) Benannte Vertragsstaaten :
**DE FR GB NL**

(56) Entgegenhaltungen :
**EP-A- 0 219 915**
**DE-A- 1 814 095**
**US-A- 3 902 090**
**Applied Optics, Band 10, Nr. 11, November 1971, C.F. Gallo: "Continuum emission spectra from long linear xenon discharge lamps with metallic halide additives", Seiten 2517-2520**

(56) Entgegenhaltungen :
**SMPTE Journal, Band 92, Nr. 2, Februar 1983, (Scarsdale, New York, US), K. Luttio et al.: "Xenon short arc lamps for film projection: the state of the art after 20 years", Seiten 184-190**

(73) Patentinhaber : **Heraeus Instruments GmbH**
**Heraeusstrasse 12-14**
**W-6450 Hanau am Main (DE)**

(72) Erfinder : **NEIGER, Manfred**
**Reinhold-Schneider-Strasse 61**
**W-7500 Karlsruhe 51 (DE)**
Erfinder : **HOPPSTOCK, Reiner**
**Rheinstrasse 56a**
**W-7500 Karlsruhe (DE)**
Erfinder : **KLEINER, Bernd**
**Postweg 41b**
**W-7500 Karlsruhe (DE)**

(74) Vertreter : **Grimm, Ekkehard**
**Heraeus Holding GmbH Heraeusstrasse 12 - 14**
**W-6450 Hanau/Main (DE)**

Jouve, 18, rue Saint-Denis, 75001 PARIS

**Beschreibung**

Die Erfindung betrifft eine Xenon-Kurzbogen-Entladungslampe mit einem hochdruckfesten Lampenkolben, der zumindest im Lichtdurchtrittsbereich aus Quarzglas besteht, wobei in den Lampenkolben zwei sich gegenüberliegende, auf einer Achse befindliche stabförmige Elektroden ragen, von denen die Anode einen größeren Durch- messer aufweist als die Kathode, mit einem Fülldruck von wenigstens 1 bar im betriebslosen Zustand und mit einem Abstand zwischen den Elektroden, der kleiner ist als der Durchmesser des Schaftes der Kathode.

Kurzbogenlampen, insbesondere Xenon-Hochdruck-Kurzbogenlampen, haben die höchsten Strahldichten aller bekannten Lampen sowie einen Bogen mit sehr kleinem Durchmesser und sehr kurzer Länge. Sie sind in guter Näherung punktförmige Lichtquellen und werden dementsprechend in Projektionsanlagen aller Art wie beispielsweise Filmprojektoren, in Lichtbogenöfen, in der Fotolitografie sowie in anderen optischen Geräten mit hohen Strahldichten eingesetzt. Sie enthalten einen hochdruckfesten Kolben mit Kugel oder ellipsoidförmigen Entladungsraum, beispielsweise aus Quarzglas, Elektroden, die als Anoden und Kathoden an eine Gleichspannungsquelle anschließbar sind und aus Wolfram bzw. Wolfram mit Zusätzen bestehen, in Kolben eingeschmolzene Stromdurchführungen, wie z.B. ein- oder mehrfach Molybdänbanddurchführungen oder Molybdänkappendurchführungen. Bekannte Kurzbogenlampen können Füllungen aus Xenon, Quecksilber, Argon, Zinn oder Zink enthalten.

Aus der GB-PS 16 03 699 ist eine solche Kurzbogenlampe mit einer Füllung aus Xenon und Quecksilber bekannt. Als Elektrodenabstände für derartige Lampen, welche auch als elektrodenstabilisierte Entladungslampen bekannt sind, werden Werte von weniger als 10 mm bis weniger als 1 mm angegeben.

Weiterhin ist aus der Zeitschrift "Illuminating Engineering", Bd. 59, 1964, Nr. 9, Seiten 589-591, eine Xenon-Kurzbogen-Entladungslampe mit einem Kolben aus Quarzglas und zwei sich gegenüberliegenden, stabförmigen Elektroden bekannt. Die Anode weist einen größeren Durchmesser auf als die Kathode; der Elektrodenabstand ist kleiner als der Schaft der Kathode, wobei die Kathodenspitze kegelförmig ausgebildet ist.

In der Zeitschrift "Applied Optics", Bd. 10, 1971, Nr. 11, Seite 2517-2520, ist eine Xenon-Entladungslampe beschrieben, die neben Xenon noch eine Dotierungssubstanz, wie z.B. Thalliumjodid, enthalten kann.

Weiterhin ist aus der CH-PS 297 983 eine Xenon-Kurzbogen-Entladungslampe bekannt, bei der die Elektroden einander auf 0,5 bis 2 mm genähert sind, so daß die positive Säule der Entladung unterdrückt wird und die Lampe nur noch im Kathodenfleck strahlt. Der aus schwerem Edelgas (Xenon) bestehenden Lampenfüllung kann ein Dotierungsgas mit einem Atomgewicht unter 21 hinzugefügt sein.

In einem solchen Fall bewirkt die Dotierung lediglich ein zusätzliches Auftreten von Spektrallinien der Dotierungssubstanz bei reduzierter Plasmatemperatur.

Ausgehend von den bekannten Kurzbogen-Entladungslampen stellt sich die Erfindung die Aufgabe, die Leuchtdichte bisher bekannter Kurzbogenlampen erheblich zu steigern, wobei eine möglichst punktförmige Entladungszone ohne Schwärzung des Lampenkolbens und ohne Einbuße an Brennstabilität angestrebt wird.

Die Aufgabe wird erfindungsgemäß durch die kennzeichnenden Merkmale des Anspruchs 1 gelöst. Unter Metallhalogeniden sind auch die Seltenerdmetallhalogenide zu verstehen. Weitere vorteilhafte Ausgestaltungen der Erfindung sind den Unteransprüchen zu entnehmen.

In einer bevorzugten Ausführungsform besteht der Lampenkolben vollständig aus Quarzglas. Als Dotierungssubstanzen werden Metallhalogenide eingesetzt. Als besonders zweckmäßig hat sich der Einsatz von Thalliumjodid als Dotierungsmaterial erwiesen, da damit eine Erniedrigung der Plasmatemperatur vermieden werden kann. Vielmehr wird eine Erhöhung der Plasmatemperatur und damit der Leuchtdichte gegenüber einer undotierten Lampe erzielt. Die Erhöhung der Leuchtdichte geht dabei im wesentlichen auf eine erhebliche Erhöhung der Kontinuumsemission zurück.

Vorteilhafterweise ist beim Einsatz von Metalljodiden als Dotierungszusatz ein Halogenidkreislauf (Wolfram-Halogen-Kreisprozeß) wirksam, bei dem das Metalljodid in der heißen Zone des Entladungsbogens dissoziiert, so daß in der Gasentladung die Metalle und das Jod in atomarer Form auftreten. Metalldampf, der zur Gefäßwand diffundiert ist, rekombiniert dort mit dem Jod und wird als Halogenid wieder in das Lampeninnere transportiert, wo es erneut dissoziiert (Jürgen Kiefer, Ultraviolette Strahlen, Walter de Gruyter Verlag, Berlin, 1977).

Als besonders vorteilhaft erweist sich die kegelförmige stumpfwinklige Kathodenspitze, da hier aufgrund der Stumpfwinkigkeit während der Brenndauer kein Material mehr zerstäubt bzw. umgeschmolzen wird.

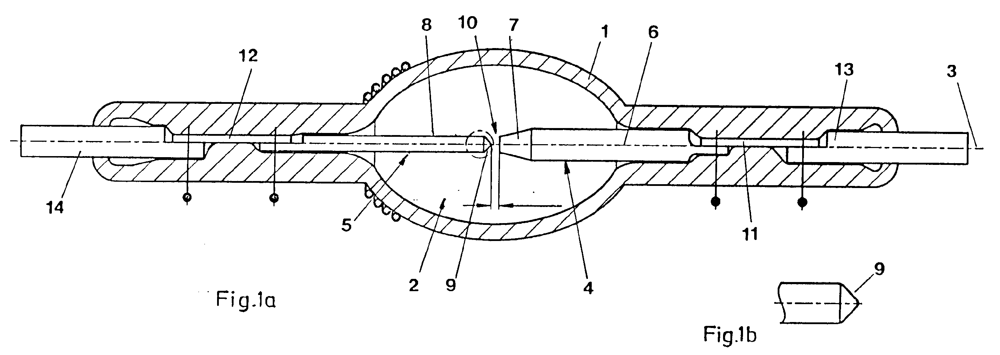

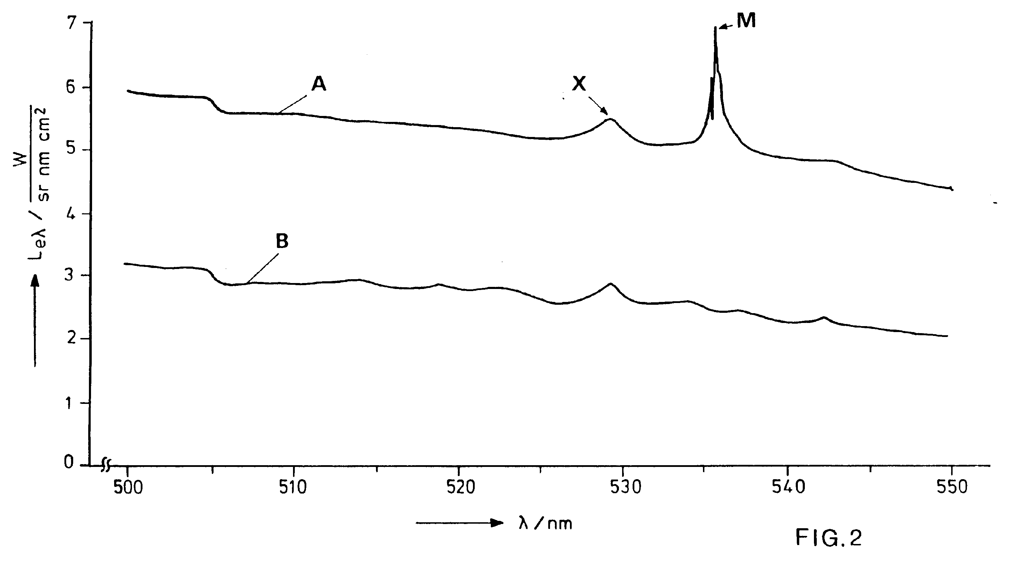

Im folgendem ist der Gegenstand der Erfindung anhand der Figuren 1a, 1b und 2 näher erläutert. Die Figuren 1a und 1b zeigen im Längsschnitt den konstruktiven Aufbau der erfindungsgemäßen Kurzbogenlampe mit Quarzglaskolben; Figur 2 zeigt das Spektrum einer mit Thalliumjodid dotierten Xenonlampe sowie das Spektrum einer undotierten Lampe.

Gemäß Figur 1a besizt die erfindungsgemäße Kurzbogenlampe einen aus Quarzglas bestehenden Lampenkolben 1 mit einem ellipsoidförmigen Entladungsraum 2. Entlang der Kolbenachse 3 ragen in den Entladungsraum 2 die Elektroden 4 und 5, welche bei diesem Ausführungsbeispiel aus Wolfram oder Wolfram mit Zusätzen bestehen. Die aus massivem Material gefertigte Anode besteht aus einem stabförmigen Schaft 6, dessen in den Entladungsraum ragende Spitze 7 als Kegelstumpf ausgebildet ist. Der Durchmesser des Schaftes 6 beträgt 3 bis 5 mm, vorzugsweise 4 mm. Gegenüber der Anode 4 ist die Kathode 5 angeordnet, welche ebenfalls aus massivem Material besteht; ihr Elektrodenschaft 8 weist einen Durchmesser von 1 bis 4 mm, vorzugsweise 2 mm, auf, wobei die in den Entladungsraum ragende Spitze 9 kegelförmig ausgebildet ist. Zwischen Anode und Kathode befindet sich die Entladungsstrecke 10, die kleiner ist als der Durchmesser der Kathode 5. Die dem Entladungsraum abgekehrten Enden der Elektroden 4, 5 sind jeweils über eine oder mehrere in den Lampenkolben druck- und temperaturfest eingeschmolzene Molybdänfolien 11, 12 jeweils mit den äußeren Lampenkontakten 13, 14 verbunden.

In Figur 1b ist die mit einem Kreis in Figur 1a markierte Spitze der Kathode vergrößert dargestellt. Anhand dieser Figur ist erkennbar, daß es sich bei der Kathodenspitze 9 um einen leicht abgerundeten Kegel handelt, der soweit optimiert ist, daß er weder zerstäubt noch umgeschmolzen wird. In dem Längsschnitt weist die Kegelspitze einen Winkel im Bereich von 85 bis 95° auf; gemäß Figur 1b hat sich als besonders zweckmäßig ein Winkel von 92° erwiesen. Da die Entladung relativ weit von der Kolbenwand stattfindet, hat diese keinen Einfluß auf die Entladungsstabilität.

Die Füllung des Entladungsraumes 2 besteht aus Xenon mit einem Kaltdruck von mehr als 1 bar sowie Dotierungssubstanzen. Aufgrund der Dotierung und des stumpfen Öffnungswinkels der Spitze 9 der Kathode wird ein stabiler Bogenansatz der Entladung ermöglicht. Durch die Dotierung wird der Bogen soweit eingeschnürt, daß die Strahldichte vor der Kathode wesentlich gesteigert wird, so daß zumindest eine Verdoppelung erzielt wird. Die Dotierung sorgt somit einerseits für die Einschnürung des Bogens und andererseits für den bereits oben erwähnten Kreisprozeß, der keine Ablagerungen, insbesondere von Wolfram, auf dem Lampenkolben zuläßt.

Beim Betrieb mit Thalliumjodid als Dotierungssubstanz entsteht eine nahezu punktförmiger Kathodenansatz. Dieser punktförmige Ansatz führt zu einer Plasmakugel vor der Kathode, deren Emission zusammen mit der Thalliumlinie zu einer bis zu mehr als zehnfachen Leuchtdichte gegenüber undotierten Xenonlampen führt. Auf diese Weise wird eine ganz entscheidende Verbesserung von dotierten Xenonlampen als Punktlichtquellen erzielt.

In Figur 2 ist anhand der Kurve A die Verdoppelung der spektralen Strahldichte im Plasmabereich einer mit Thalliumjodid dotierten Xenonlampe gegenüber der in Kurve B dargestellten spektralen Strahldichte im Plasmabereich einer undotierten Xenonlampe erkennbar. Für Kurve A ist insbesondere das mit M bezeichnete Maximum der spektralen Strahldichte im Bereich von 535 nm charakteristisch, das der Thalliumlinie entspricht. Die mit X bezeichnete Spitze der Kurve A entspricht einer Xenon-Ionenlinie.

Die erfindungsgemäße Xenon-Hochdruckkurzbogenlampe reguliert die extrem starke Wolfram-Abdampfung des kathodischen Brennfleckbetriebes aufgrund eines Strömungs-kontrollierten Wolfram-Halogen-Kreisprozesses (1-20 m/s Strömungsgeschwindigkeit); auf diese Weise wird ein stabiler Brennfleckbetrieb erzielt und die Kolbeninnenwand bleibt frei von Wolframniederschlägen.

Weiterhin ist es möglich als Dotierungssubstanzen Halogenide der zweiten Nebengruppe des periodischen Systems, insbesondere Quecksilberjodid, einzusetzen; es können auch Alkalimetallhalogenide oder Seltenerdmetallhalogenide als Dotierungssubstanzen verwendet werden; es ist auch möglich eine Mischung dieser verschiedenartigen Halogenide einzusetzen.

Die erfindungsgemäße Xenon-Hochdruckkurzbogenlampe kann zusätzlich mit einer Anoden-Wärmestaunut in Form einer die Anode umgebenden Ringnut versehen werden, wodurch wesentlich höhere spezifische Anodenbelastungen ohne Schädigung der Gefäßwände möglich sind, was extrem hohe spezifische Lampenbelastungen (größer 200 W/ccm) und deshalb extrem hohe Betriebsdrucke (größer oder gleich 80 bar) erlaubt. Der Elektrodenabstand liegt vorzugsweise im Bereich von 0,1 bis 2 mm, wobei die elektrische Leistung der Lampe maximal 1 KW beträgt. Nach der Erfindung wird ein extrem eingeschnürter kathodischer Brennfleckbetrieb induziert, der die höchsten bekannten Dauerstrichstrahldichten erzeugt (größer 30 W/ccm*sr*nm), wie sie beispielsweise beim Einsatz der Lampe als Pumplichtquelle für Dauerstrich-Farbstofflaser erwünscht sind.

## Patentansprüche

1. Xenon-Kurzbogen-Entladungslampe mit einem hochdrutkfesten Lampenkolben, der zumindest im Lichtdurchtrittsbereich aus quarzglas besteht, wobei in den Lampenkolben zwei sich gegenüberliegende, auf einer Achse befindlithe stabförmige Elektroden ragen, von denen die Anode einen größeren Durchmesser aufweist als die Kathode, mit einem Fülldruck von wenigstens 1 bar im betriebslosen Zustand und mit einem Abstand zwischen den Elektroden, der kleiner ist als der Durchmesser des Schaftes der Kathode, dadurch gekennzeichnet, daß die Spitze der Kathode (5) kegelförmig ausgebildet ist und daß die Lampe wenigstens ein Metallhalogenid als Dotierungssubstanz enthält.

2. Lampe nach Anspruch 1, dadurch gekennzeichnet, daß der Lampenkolben (1) vollständig aus quarzglas besteht.

3. Lampe nach Anspruch 1 oder 2, dadurch gekennzeichnet, daß der Abstand zwischen den Elektroden (4, 5) in Abhängigkeit von der Leistungsaufnahme der Lampe gewählt ist.

4. Lampe nach Anspruch 3, dadurch gekennzeichnet, daß diese für eine Leistungsaufnahme bis zu 20 KW ausgebildet ist, wobei der Abstand (10) der Elektroden im Bereich von 0,2 bis 5 mm liegt.

5. Lampe nach einem der Ansprüche 1 bis 4, dadurch gekennzeichnet, daß die Dotierungssubstanz Thalliumjodid ist.

6. Lampe nach einem oder mehreren der Ansprüche 1 bis 5, dadurch gekennzeichnet, daß die Dotierungssubstanz Indiumjodid ist.

7. Lampe nach einem der Ansprüche 1 bis 6 dadurch gekennzeichnet, daß die Dotierungssubstanz Galliumjodid ist.

8. Lampe nach einem der Ansprüche 1 bis 7, dadurch gekennzeichnet, daß die Dotierungssubstanz Kaliumjodid ist.

9. Lampe nach einem der Ansprüche 1 bis 8, dadurch gekennzeichnet, daß die Dotierungssubstanz ein jodid der zweiten Nebengruppe des periodischen Systems ist.

10. Lampe nach Anspruch 9, dadurch gekennzeichnet, daß die Dotierungssubstanz Quecksilberjodid ist.


## Claims

1. A xenon short arc discharge lamp with a lamp bulb which is resistant to high pressure and which consists of quartz glass at least in the light passage region, in which two rod-shaped electrodes, situated on one axis and lying opposite each other, protrude into the lamp bulb, the anode of which has a greater diameter than the cathode, with an inflation pressure of at least 1 bar in non-operational state and with a distance between the electrodes which is smaller than the diameter of the shaft of the cathode, characterised in that the tip of the cathode (5) is constructed in a tapered shape and that the lamp contains at least a metal halide as doping substance.

2. A lamp according to Claim 1, characterised in that the lamp bulb (1) consists entirely of quartz glass.

3. A lamp according to Claim 1 or 2, characterised in that the distance between the electrodes (4, 5) is selected as a function of the power input of the lamp.

4. A lamp according to Claim 3, characterised in that it is constructed for a power input of up to 20 KW, in which the distance (10) of the electrodes lies in the region of 0.2 to 5 mm.

5. A lamp according to one of Claims 1 to 4, characterised in that the doping substance is thallium iodide.

6. A lamp according to one or more of Claims 1 to 5, characterised in that the doping substance is indium iodide.

7. A lamp according to one of Claims 1 to 6, characterised in that the doping substance is gallium iodide.

8. A lamp according to one of Claims 1 to 7, characterised in that the doping substance is potassium iodide.

9. A lamp according to one of Claims 1 to 8, characterised in that the doping substance is an iodide of the second sub-group of the periodic system.

10. A lamp according to Claim 9, characterised in that the doping substance is mercury iodide.


## Revendications

1. Lampe à décharge d'arc court dans le xénon, comportant: une ampoule résistant aux fortes pressions, faite en verre quartzeux au moins dans la zone de passage de la lumière, et deux électrodes en forme de tige situées en vis-à-vis sur un axe et pénétrant dans ladite ampoule, l'anode présentant un diamètre plus important que la cathode, la pression de remplissage étant d'au moins 1 bar dans la condition inactivée, et la distance entre les électrodes étant plus petite que le diamètre de la tige de la cathode, caractérisée par le fait que la pointe de la cathode (5) est de forme conique et par le fait que la lampe contient au moins un halogénure de métal, en tant que substance de dopage.

2. Lampe selon la revendication 1, caractérisée par le fait que l'ampoule (1) est entièrement en verre quartzeux.

3. Lampe selon revendication 1 ou 2, caractérisée par le fait que l'intervalle entre les électrodes (4, 5) est choisi en fonction de la puissance absorbée par la lampe.

4. Lampe selon revendication 3, caractérisée par le fait qu'elle est conçue pour une consommation de puissance allant jusqu'à 20 kW, l'intervalle (10) des électrodes étant compris dans une plage allant de 0,2 à 5 millimètres.

5. Lampe selon l'une des revendications 1 à 4, caractérisée par le fait que la substance de dopage est l'iodure de thallium.

6. Lampe selon une ou plusieurs des revendications 1 à 5, caractérisée par le fait que la substance de dopage est l'iodure d'indium.

7. Lampe selon l'une des revendications 1 à 6, caractérisée par le fait que la substance de dopage est l'iodure de gallium.

8. Lampe selon l'une des revendications 1 à 7, caractérisée par le fait que la substance de dopage est l'iodure de potassium.

9. Lampe selon l'une des revendications 1 à 8, caractérisée par le fait que la substance de dopage est un iodure du deuxième sous-groupe du système périodique.

10. Lampe selon revendication 9, caractérisée par le fait que la substance de dopage est l'iodure de mercure.

Fig.1b

Fig.1a

FIG.2